(19) Europäisches Patentamt

European Patent Office

Office européen des brevets

(11) **EP 4 321 891 A1**

(12) **EUROPEAN PATENT APPLICATION**

(43) Date of publication:
**14.02.2024 Bulletin 2024/07**

(21) Application number: **22189932.1**

(22) Date of filing: **11.08.2022**

(51) International Patent Classification (IPC):
**G01R 33/56** (2006.01)        **G01R 33/565** (2006.01)

(52) Cooperative Patent Classification (CPC):
**G01R 33/56509; G01R 33/5608; G01R 33/56563;**
**G01R 33/4828**

(84) Designated Contracting States:
**AL AT BE BG CH CY CZ DE DK EE ES FI FR GB**
**GR HR HU IE IS IT LI LT LU LV MC MK MT NL NO**
**PL PT RO RS SE SI SK SM TR**
Designated Extension States:
**BA ME**
Designated Validation States:
**KH MA MD TN**

(71) Applicant: **Koninklijke Philips N.V.**
**5656 AG Eindhoven (NL)**

(72) Inventor: **EGGERS, Holger**
**Eindhoven (NL)**

(74) Representative: **Philips Intellectual Property &**
**Standards**
**High Tech Campus 52**
**5656 AG Eindhoven (NL)**

(54) **TWO-STAGE DENOISING FOR MAGNETIC RESONANCE IMAGING**

(57)    Disclosed herein is a medical system (100, 300) comprising a memory (110) storing machine executable instructions (120). The medical system further comprises a computational system (104). The execution of the machine executable instructions causes the computational system to receive (200) a series of complex valued magnetic resonance images (126) each of a field of view of a subject according to a magnetic resonance imaging protocol; receive (202) a series of complex valued denoised images (128) by inputting the series of complex valued magnetic resonance images into a first noise filtering module (122); calculate (204) a correction mapping (130) from the series of complex valued denoised images; reconstruct (206) a corrected magnetic resonance image (132) using the correction mapping and the series of complex valued magnetic resonance images; and receive (208) a denoised magnetic resonance image (134) by inputting the corrected magnetic resonance image into a second noise filtering module (124).

Fig. 1

**Description**

FIELD OF THE INVENTION

The invention relates to magnetic resonance imaging, in particular to the denoising of magnetic resonance images.

BACKGROUND OF THE INVENTION

Magnetic resonance imaging (MRI) often suffers from a poor signal-to-noise ratio (SNR) and from various types of image artifacts, arising from motion of the subject, inhomogeneity of the main magnetic field Bo, and imperfections of the gradient system, among others. Various methods aim at reducing noise, suppressing artifacts, or both.

For example, United States patent application publication US2022026516A1 discloses a computer-implemented method of correcting phase and reducing noise in magnetic resonance (MR) phase images. The method includes executing a neural network model for analyzing MR images, wherein the neural network model is trained with a pair of pristine images and corrupted images, wherein the corrupted images include corrupted phase information, the pristine images are the corrupted images with the corrupted phase information reduced, and target output images of the neural network model are the pristine images. The method further includes receiving MR images including corrupted phase information, and analyzing the received MR images using the neural network model. The method also includes deriving pristine phase images of the received MR images based on the analysis, wherein the derived pristine phase images include reduced corrupted phase information, compared to the received MR images, and outputting MR images based on the derived pristine phase images.

SUMMARY OF THE INVENTION

The invention provides for a medical system, a computer program, and a method in the independent claims. Embodiments are given in the dependent claims.

Many magnetic resonance imaging techniques rely on multiple acquisitions or subacquisitions of k-space data. The k-space data from these acquisitions or subacquisitions are often inconsistent for various reasons, which makes it difficult to combine them later into one resulting image. Moreover, many magnetic resonance imaging techniques provide rather noisy k-space data, which impedes any attempt to render the k-space data from these acquisitions or subacquisitions consistent, let alone to read the resulting image. Embodiments may provide for an improved means of reducing noise and suppressing artifacts arising from inconsistent k-space data in the resulting image. To achieve this a series of complex valued magnetic resonance images are put into a first noise filtering module to provide for a series of complex valued denoised images. The series of complex valued denoised images are then used to make a correction mapping. This could for example be a per image phase correction mapping or motion correction mapping. The correction mapping is then applied to the original series of complex valued magnetic resonance images to reconstruct a corrected magnetic resonance image. A denoised magnetic resonance image is then received by inputting the corrected magnetic resonance image into a second noise filtering module.

In one aspect the invention provides for a medical system. The medical system comprises memory that stores machine executable instructions. The memory also stores a first noise filtering module. The memory further stores a second noise filtering module. The medical system further comprises a computational system. The execution of the machine executable instructions causes the computational system to receive a series of complex valued magnetic resonance images each of a field of view of the subject and acquired according to a magnetic resonance imaging protocol.

The magnetic resonance imaging protocol may be specified or identified by the context of the complex valued magnetic resonance images. For example, the format of the images may implicitly specify the magnetic resonance imaging protocol. The series of complex valued magnetic resonance images may be accompanied by data or metadata which identifies the magnetic resonance imaging protocol and/or other acquisition details, or there may be metadata which accompanies the series of complex valued magnetic resonance images that identify the magnetic resonance imaging protocol.

Execution of machine executable instructions further causes the computational system to receive a series of complex valued denoised images by inputting the series of complex valued magnetic resonance images into the first noise filtering module. Execution of the machine executable instructions further causes the computational system to calculate a correction mapping from the series of complex valued denoised images. Execution of the machine executable instructions further causes the computational system to reconstruct a corrected magnetic resonance image using the correction mapping and the series of complex valued magnetic resonance images.

Execution of the machine executable instructions further causes the computational system to receive a denoised magnetic resonance image by inputting the corrected magnetic resonance image into the second noise filtering module.

This embodiment may be beneficial because it may provide for means of producing a denoised magnetic resonance image of superior quality. In embodiments the series of complex valued magnetic resonance images are first processed with the first noise filtering module to provide the series of complex valued denoised images. The correction mapping is calculated from this series of complex valued denoised images. This correction mapping is then used to reconstruct the corrected magnetic resonance image from the original series of complex valued magnetic resonance images. The corrected magnetic resonance image therefore has not been degraded by the first noise filtering module. This two-step process results in a denoised magnetic resonance image that may have fewer artifacts.

The first noise filtering module and the second noise filtering module in some examples may be identical. In other examples the first noise filtering module and the second noise filtering module may be distinct. A noise filtering module as used here in encompasses a software module which receives as input an image and which provides as output a denoised image. The first noise filtering module and the second noise filtering module may be implemented using algorithms or may be implemented using a neural network.

Examples of neural networks which may be used for denoising images include: DnCNN, Recurrent CNN, UNet, and Simplified DenseNet. In particular, Mohan et. al. describe a deep convolutional neural network in "Robust and interpretable blind image denoising via bias-free convolutional neural networks" (arXiv: 1906.05478) which would be suitable for implementing the first noise filtering neural network and/or the second noise filtering neural network.

In another embodiment the correction mapping comprises a phase correction mapping calculated for each of the series of complex valued denoised images individually. Execution of the machine executable instructions further causes the computational system to calculate a series of phase corrected images by applying the phase correction mapping to each of the series of complex valued magnetic resonance images. The corrected magnetic resonance image is calculated from the series of phase corrected images. This embodiment may be beneficial when the phase of the series of complex valued magnetic resonance images is inconsistent.

In another embodiment the phase correction mapping is calculated for each of the series of complex valued denoised images individually by fitting a parameterized polynomial to the spatially dependent phase of each of the series of complex valued denoised images. This embodiment may be beneficial because it may provide for a robust means of calculating the phase correction mapping for each of the series of complex valued denoised images individually.

As an example, a parameterized polynomial p'(x,y) of order N to individually describe the spatially dependent phase p(x,y) of each of the series of complex valued denoised images is given by:

$$p'(x, y) = \sum_{m,n=0}^{N} c_{m,n} x^m y^n,$$

where the parameters $C_{m,n}$ are determined by minimizing:

$$\sum_{x,y} m(x,y)(p(x,y) - mod(p'(x,y) + \pi, 2\pi) - \pi),$$

with the spatially dependent magnitude m(x,y).

In another embodiment the magnetic resonance imaging protocol is a diffusion weighted magnetic resonance imaging protocol. The corrected magnetic resonance image is calculated from the series of phase corrected images by averaging the series of phase corrected images. This embodiment may be beneficial when complex averaging of the series of complex valued magnetic resonance images leads to signal cancellation due to phase variations in the series of complex valued magnetic resonance images.

In another embodiment the magnetic resonance imaging protocol is a bipolar readout magnetic resonance imaging protocol. Execution of the machine executable instructions further causes the computational system to calculate the corrected magnetic resonance image from the series of phase corrected images by calculating a series of phase corrected magnetic resonance images by applying the phase correction mapping to the series of complex valued magnetic resonance images. Execution of the machine executable instructions further causes the computational system to calculate the corrected magnetic resonance image by calculating phase corrected k-space data by transforming the series of phase corrected images to k-space. The corrected magnetic resonance image is then reconstructed from a combination of the phase corrected k-space data. In essence each of the series of phase corrected images is converted to k- space. The k-space data are then combined and used to calculate the corrected magnetic resonance image. This combination may be achieved in different ways. In some instances, the k-space data are simply grouped together and combined. In other instances, the k-space data are very similar and may be averaged.

In another embodiment the correction mapping comprises a main field inhomogeneity correction mapping that is calculated from the series of complex valued denoised images. Execution of the machine executable instructions further causes the computational system to calculate a series of phase corrected images by applying the main field inhomogeneity correction mapping to each of the series of complex valued magnetic resonance images. The corrected magnetic resonance image is calculated from the series of phase corrected images.

In another embodiment the magnetic resonance imaging protocol is a Dixon magnetic resonance imaging protocol and the corrected magnetic resonance image may be a Dixon magnetic resonance image, such as a water-only image or a fat-only image This embodiment may be beneficial because it may provide for an improved means of Dixon imaging.

In another embodiment the magnetic resonance imaging protocol is an echo planar magnetic resonance imaging protocol configured for acquiring the series of complex valued magnetic resonance images with two blip gradient polarities. The echo planar magnetic resonance imaging protocol comprises a series of readout gradients with alternating polarity, between which blip gradients are applied perpendicular to the readout gradients to acquire k-space data along multiple lines in opposite directions after a single excitation. The polarity of the blip gradients determines the direction in which distortions occur in the presence of main field inhomogeneity. The correction mapping comprises a distortion correction mapping. Execution of the machine executable instructions further causes the computational system to calculate the distortion correction mapping by sorting the series of complex valued magnetic resonance images into a first group with a first blip gradient polarity and a second group with a second blip gradient polarity. Execution of the machine executable instructions further causes the computational system to calculate the distortion correction mapping by registering the images from the first group with the images from the second group.

Execution of the machine executable instructions further causes the computational system to calculate a series of distortion corrected images by applying the distortion correction mapping to the series of complex valued magnetic resonance images. The corrected magnetic resonance image is reconstructed by averaging the series of distortion corrected images. The average of the distortion corrected images could either be complex or real valued. For example, the average could be an average of the magnitude values of the series of distortion corrected images.

In another embodiment the correction mapping comprises a motion correction mapping that is calculated from the series of complex value denoised images with respect to a reference image. In one example, reference image could be chosen from the series of complex valued denoised images. In another example the reference image could be another image from another source such as a prior image acquired of the subject. One of the complex valued denoised images is selected as a reference for all of the other images. A motion correction mapping is then determined that maps those images onto the reference image. This embodiment may be beneficial because the motion correction may be more accurate when denoising is applied to these individual images.

In another embodiment execution of the machine executable instructions further causes the computational system to calculate a series of motion corrected complex valued magnetic resonance images by applying the motion correction mapping to the series of complex valued magnetic resonance images. Execution of the machine executable instruction further causes the computational system to calculate motion corrected k-space data by transforming the series of motion corrected magnetic resonance images to k-space. The corrected magnetic resonance image is reconstructed from a combination of the motion corrected k-space data.

In this embodiment the series of motion corrected magnetic resonance images are first each converted into k-space data to form motion corrected k-space data. The k-space data from the individual images are then combined collectively. This may involve simply aggregating the k-space data or it may involve averaging the k-space data.

In another embodiment the magnetic resonance imaging protocol is a segmented multi shot magnetic resonance imaging protocol.

In another embodiment the magnetic resonance imaging protocol is a PROPELLER magnetic resonance imaging protocol. In the case of a PROPELLER magnetic resonance imaging protocol, the series of complex valued magnetic resonance images are images reconstructed from individual "blades" of k-space data.

In another embodiment the motion correction mapping is a rigid body mapping. In this embodiment the transformation from image to image is a rigid body mapping, without any deformation.

In another embodiment the motion correction mapping is an affine mapping. In this embodiment the transformation from image to image is an affine mapping.

In another embodiment the motion correction mapping is a displacement field.

For the rigid body mapping, the affine mapping, and the displacement field various algorithms may be used. For example, an anatomical atlas may be used to map points between various images. Alternatively, a shape deformable model may be used.

In another embodiment the medical system further comprises a magnetic resonance imaging system. The memory further comprises pulse sequence commands configured to control the magnetic resonance imaging system to acquire the measured k-space data according to the magnetic resonance imaging protocol. Execution of the machine executable instructions further causes the computational system to control the magnetic resonance imaging system with the pulse sequence commands to acquire the measured k-space data. The k-space data comprises multiple discrete acquisitions each descriptive of the field of view of a subject.

Execution of the machine executable instructions further causes the computational system to reconstruct the series of complex valued magnetic resonance images each of the field of view of the subject from the measured k-space data. In some examples each of the discrete acquisitions may be used to reconstruct a different image in the series of complex valued magnetic resonance images.

In another aspect the invention provides for a computer program that comprises machine executable instructions. The computer program may for example be stored on a non-transitory storage medium. The computer program further comprises a first noise filtering module and a second noise filtering module. Execution of the machine executable instructions causes a computational system to receive a series of complex valued magnetic resonance images each of a field of view of a subject according to a magnetic resonance imaging protocol.

Execution of the machine executable instructions further causes the computational system to receive a series of complex valued denoised images by inputting this series of complex valued magnetic resonance images into the first noise filtering module. Execution of the machine executable instructions further causes the computational system to calculate a correction mapping from the series of complex valued denoised images. Execution of the machine executable instructions further causes the computational system to reconstruct a corrected magnetic resonance image using the correction mapping and the series of complex valued magnetic resonance images. Execution of the machine executable instructions further causes the computational system to receive a denoised magnetic resonance image by inputting the corrected magnetic resonance image into the second noise filtering module.

In another aspect the invention provides for a method of medical imaging. The method comprises receiving a series of complex valued magnetic resonance images each of a field of view of a subject according to a magnetic resonance imaging protocol. The method further comprises receiving a series of complex valued denoised images by inputting the series of complex valued magnetic resonance images into a first noise filtering module. The method further comprises calculating a correction mapping from the series of complex valued denoised images. The method further comprises reconstructing a corrected magnetic resonance image using the correction mapping and the series of complex valued magnetic resonance images. The method further comprises receiving a denoised magnetic resonance image by inputting the corrected magnetic resonance image into a second noise filtering module.

It is understood that one or more of the aforementioned embodiments of the invention may be combined as long as the combined embodiments are not mutually exclusive.

As will be appreciated by one skilled in the art, aspects of the present invention may be embodied as an apparatus, method or computer program product. Accordingly, aspects of the present invention may take the form of an entirely hardware embodiment, an entirely software embodiment (including firmware, resident software, micro-code, etc.) or an embodiment combining software and hardware aspects that may all generally be referred to herein as a "circuit," "module" or "system". Furthermore, aspects of the present invention may take the form of a computer program product embodied in one or more computer readable medium(s) having computer executable code embodied thereon.

Any combination of one or more computer readable medium(s) may be utilized. The computer readable medium may be a computer readable signal medium or a computer readable storage medium. A 'computer-readable storage medium' as used herein encompasses any tangible storage medium which may store instructions which are executable by a processor or computational system of a computing device. The computer-readable storage medium may be referred to as a computer-readable non-transitory storage medium. The computer-readable storage medium may also be referred to as a tangible computer readable medium. In some embodiments, a computer-readable storage medium may also be able to store data which is able to be accessed by the computational system of the computing device. Examples of computer-readable storage media include, but are not limited to, a floppy disk, a magnetic hard disk drive, a solid state hard disk, flash memory, a USB thumb drive, Random Access Memory (RAM), Read Only Memory (ROM), an optical disk, a magneto-optical disk, and the register file of the computational system. Examples of optical disks include Compact Disks (CD) and Digital Versatile Disks (DVD), for example CD-ROM, CD-RW, CD-R, DVD-ROM, DVD-RW, or DVD-R disks. The term computer readable-storage medium also refers to various types of recording media capable of being accessed by the computer device via a network or communication link. For example, data may be retrieved over a modem, over the internet, or over a local area network. Computer executable code embodied on a computer readable medium may be transmitted using any appropriate medium, including but not limited to wireless, wire line, optical fiber cable, RF, etc., or any suitable combination of the foregoing.

A computer readable signal medium may include a propagated data signal with computer executable code embodied therein, for example, in baseband or as part of a carrier wave. Such a propagated signal may take any of a variety of forms, including, but not limited to, electro-magnetic, optical, or any suitable combination thereof. A computer readable signal medium may be any computer readable medium that is not a computer readable storage medium and that can communicate, propagate, or transport a program for use by or in connection with an instruction execution system, apparatus, or device.

'Computer memory' or 'memory' is an example of a computer-readable storage medium. Computer memory is any memory which is directly accessible to a computational system. 'Computer storage' or 'storage' is a further example of a computer-readable storage medium. Computer storage is any non-volatile computer-readable storage medium. In some embodiments computer storage may also be computer memory or vice versa.

A 'computational system' as used herein encompasses an electronic component which is able to execute a program or machine executable instruction or computer executable code. References to the computational system comprising the example of "a computational system" should be interpreted as possibly containing more than one computational system or processing core. The computational system may for instance be a multi-core processor. A computational system may also refer to a collection of computational systems within a single computer system or distributed amongst multiple computer systems. The term computational system should also be interpreted to possibly refer to a collection or network of computing devices each comprising a processor or computational systems. The machine executable code or instructions may be executed by multiple computational systems or processors that may be within the same computing device or which may even be distributed across multiple computing devices.

Machine executable instructions or computer executable code may comprise instructions or a program which causes a processor or other computational system to perform an aspect of the present invention. Computer executable code for carrying out operations for aspects of the present invention may be written in any combination of one or more programming languages, including an object oriented programming language such as Java, Smalltalk, C++ or the like and conventional procedural programming languages, such as the "C" programming language or similar programming languages and compiled into machine executable instructions. In some instances, the computer executable code may be in the form of a high-level language or in a pre-compiled form and be used in conjunction with an interpreter which generates the machine executable instructions on the fly. In other instances, the machine executable instructions or computer executable code may be in the form of programming for programmable logic gate arrays.

The computer executable code may execute entirely on the user's computer, partly on the user's computer, as a stand-alone software package, partly on the user's computer and partly on a remote computer or entirely on the remote computer or server. In the latter scenario, the remote computer may be connected to the user's computer through any type of network, including a local area network (LAN) or a wide area network (WAN), or the connection may be made to an external computer (for example, through the Internet using an Internet Service Provider).

Aspects of the present invention are described with reference to flowchart illustrations and/or block diagrams of methods, apparatus (systems) and computer program products according to embodiments of the invention. It is understood that each block or a portion of the blocks of the flowchart, illustrations, and/or block diagrams, can be implemented by computer program instructions in form of computer executable code when applicable. It is further understood that, when not mutually exclusive, combinations of blocks in different flowcharts, illustrations, and/or block diagrams may be combined. These computer program instructions may be provided to a computational system of a general purpose computer, special purpose computer, or other programmable data processing apparatus to produce a machine, such that the instructions, which execute via the computational system of the computer or other programmable data processing apparatus, create means for implementing the functions/acts specified in the flowchart and/or block diagram block or blocks.

These machine executable instructions or computer program instructions may also be stored in a computer readable medium that can direct a computer, other programmable data processing apparatus, or other devices to function in a particular manner, such that the instructions stored in the computer readable medium produce an article of manufacture including instructions which implement the function/act specified in the flowchart and/or block diagram block or blocks.

The machine executable instructions or computer program instructions may also be loaded onto a computer, other programmable data processing apparatus, or other devices to cause a series of operational steps to be performed on the computer, other programmable apparatus or other devices to produce a computer implemented process such that the instructions which execute on the computer or other programmable apparatus provide processes for implementing the functions/acts specified in the flowchart and/or block diagram block or blocks.

A 'user interface' as used herein is an interface which allows a user or operator to interact with a computer or computer system. A 'user interface' may also be referred to as a 'human interface device.' A user interface may provide information or data to the operator and/or receive information or data from the operator. A user interface may enable input from an operator to be received by the computer and may provide output to the user from the computer. In other words, the user interface may allow an operator to control or manipulate a computer and the interface may allow the computer to indicate the effects of the operator's control or manipulation. The display of data or information on a display or a graphical user interface is an example of providing information to an operator. The receiving of data through a keyboard, mouse, trackball, touchpad, pointing stick, graphics tablet, joystick, gamepad, webcam, headset, pedals, wired glove, remote control, and accelerometer are all examples of user interface components which enable the receiving of information or data from an operator.

A 'hardware interface' as used herein encompasses an interface which enables the computational system of a computer system to interact with and/or control an external computing device and/or apparatus. A hardware interface may allow a computational system to send control signals or instructions to an external computing device and/or apparatus. A hardware interface may also enable a computational system to exchange data with an external computing device and/or apparatus. Examples of a hardware interface include, but are not limited to, a universal serial bus, IEEE 1394 port, parallel port, IEEE 1284 port, serial port, RS-232 port, IEEE-488 port, Bluetooth connection, Wireless local area network connection, TCP/IP connection, Ethernet connection, control voltage interface, MIDI interface, analog input interface, and digital input interface.

A 'display' or 'display device' as used herein encompasses an output device or a user interface adapted for displaying images or data. A display may output visual, audio, and/or tactile data. Examples of a display include, but are not limited to, a computer monitor, a television screen, a touch screen, tactile electronic display, Braille screen, Cathode ray tube (CRT), Storage tube, Bi-stable display, Electronic paper, Vector display, Flat panel display, Vacuum fluorescent display (VF), Light-emitting diode (LED) displays, Electroluminescent display (ELD), Plasma display panels (PDP), Liquid crystal display (LCD), Organic light-emitting diode displays (OLED), a projector, and Head-mounted display.

K-space data are defined herein as being the Fourier transform of a magnetic resonance image. The k-space data in one example may be the recorded measurements of radio frequency signals emitted by atomic spins using the antenna of a magnetic resonance apparatus during a magnetic resonance imaging scan. In another example, the k-spaced data are formed by taking an inverse Fourier transform of an existing magnetic resonance image.

A Magnetic Resonance image is defined herein as being the reconstructed two- or three-dimensional visualization of anatomic data contained within the magnetic resonance imaging data. This visualization can be performed using a computer.

BRIEF DESCRIPTION OF THE DRAWINGS

In the following preferred embodiments of the invention will be described, by way of example only, and with reference to the drawings in which:

Fig. 1 illustrates an example of a medical system;
Fig. 2 shows a flow chart which illustrates a method of using the medical system of Fig. 1;
Fig. 3 illustrates a further example of a medical system;
Fig. 4 shows a flow chart which illustrates a method of using the medical system of Fig. 3;
Fig. 5 shows a flow chart which illustrates a further example of a method;
Fig. 6 shows a flow chart which illustrates a further example of a method;
Fig. 7 shows a flow chart which illustrates a further example of a method;
Fig. 8 shows a flow chart which illustrates a further example of a method;
Fig. 9 shows a flow chart which illustrates a further example of a method;
Fig. 10 shows a flow chart which illustrates a further example of a method;
Fig. 11 illustrates the calculation of a diffusion weighted magnetic resonance image;
Fig. 12 illustrates the denoising of individual images used to construct a diffusion weighted magnetic resonance image;
Fig. 13 illustrates the phase correction of the images in Fig. 12; and
Fig. 14 illustrates the complex combination of individual images for diffusion weighted magnetic resonance imaging.

DESCRIPTION OF EMBODIMENTS

Like numbered elements in these figures are either equivalent elements or perform the same function. Elements which have been discussed previously will not necessarily be discussed in later figures if the function is equivalent.

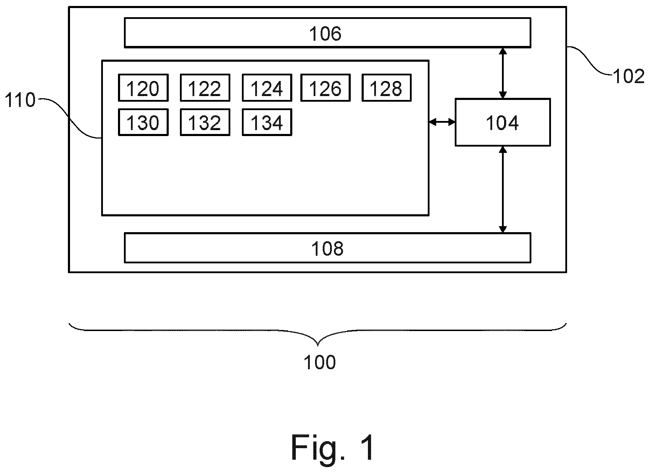

Fig. 1 illustrates an example of a medical system 100. The medical system 100 is shown as comprising a computer 102. The computer 102 is intended to represent one or more computers that may be at one or more locations. The computer 102 is shown as comprising a computational system 104. Likewise, the computational system 104 is intended to represent one or more computational systems or cores that are located at one or more locations. The computational system 104 is shown as being in communication with an optional hardware interface 106 and an optional user interface 108. The hardware interface 106 if present may be used to communicate and control other components of the medical system 100 if they are present. For example, the hardware interface 106 may be used for controlling a magnetic resonance imaging system. The user interface 108 may be used by a user or a technician to control the operation and function of the medical system 100.

The computational system 104 is further shown as being in communication with a memory 110. The memory 110 is intended to represent one or more types of memory which are accessible to the computational system 104. For example, the memory 110 could be a non-transitory storage medium.

The memory 110 is shown as storing machine executable instructions 120. The machine executable instructions 120 enable the computational system 104 to perform basic tasks such as computations and image processing tasks. The memory 110 is further shown as containing a first noise filtering module 122 and a second noise filtering module 124. Both noise filtering modules 122 and 124 are configured to receive an image as input and then to output a denoised image. These noise filtering modules 122 and 124 may be either algorithmic or may be neural network based. In some examples, the first noise filter module 122 and the second noise filtering module 124 are the same noise filtering module.

The memory 110 is further shown as containing a series of complex valued magnetic resonance images 126. Each of these images 126 is of a field of view of a subject according to a magnetic resonance imaging protocol. The magnetic resonance imaging protocol specifies the technique which was used to acquire the series of complex valued magnetic resonance images 126. The magnetic resonance imaging protocol may also specify the relationship between the various images. For example, it is possible that the series of complex valued magnetic resonance images 126 is accompanied by metadata that specify the magnetic resonance imaging protocol. The series of complex valued magnetic resonance images 126 may be encapsulated within a DICOM file that provides this information.

The memory 110 is further shown as containing a series of complex valued denoised images 128. The series of complex valued denoise images was obtained by inputting the series of complex valued magnetic resonance images 126 into the first noise filtering module 122.

The memory 110 is further shown as containing a correction mapping 130 that was calculated from the series of complex valued denoised images 128. This correction mapping 130 may take different forms in different examples. In some examples it may be a motion correction or it may be a correction of distortions within the individual images 128. The memory 110 is further shown as containing a corrected magnetic resonance image 132 that has been calculated or reconstructed using the correction mapping 130 and the series of complex valued magnetic resonance images 126. The memory 110 is further shown as containing a denoised magnetic resonance image 134. The denoised magnetic resonance image 134 was constructed by inputting the corrected magnetic resonance image 132 into the second noise filtering module 124. It should be noted that in some examples the first noise filtering module 122 and the second noise filtering module 124 are identical. In other examples the first noise filtering module 122 may be tailored to the series of complex valued magnetic resonance images 126 and the second noise filtering module 124 may be tailored to the corrected magnetic resonance image 132.

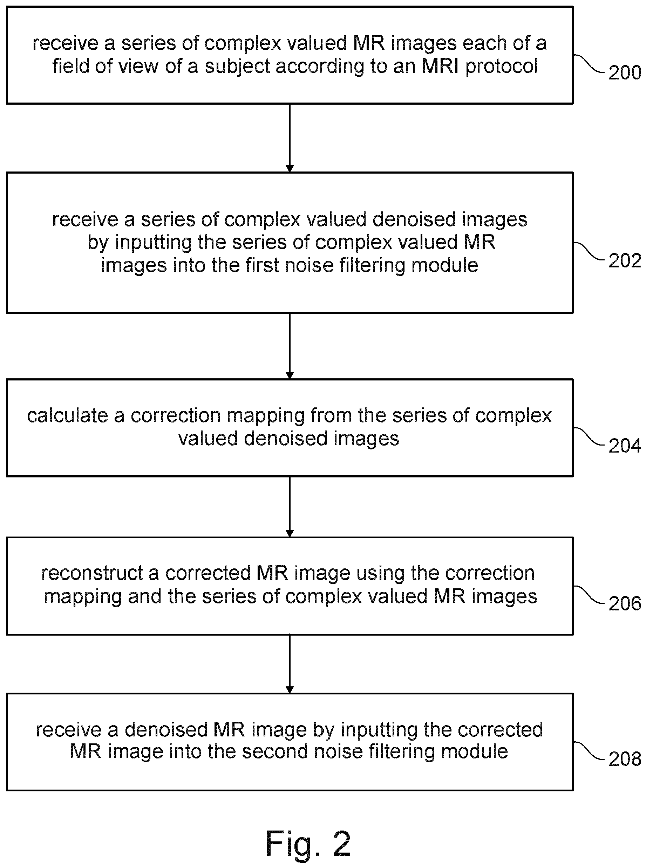

Fig. 2 shows a flow chart which illustrates a method of operating the medical system 100 of Fig. 1. First in step 200 the series of complex valued magnetic resonance images 126 is received. Next in step 202 the series of complex valued denoised images 128 is received by inputting the series of complex valued magnetic resonance images 126 into the first noise filtering module 122. Then in step 204 the correction mapping 130 is calculated from the series of complex valued denoised images 128. Next in step 206 the corrected magnetic resonance image 132 is reconstructed using the correction mapping 130 and the series of complex valued magnetic resonance images 126. Finally in step 208, the denoised magnetic resonance image 134 is received by inputting the corrected magnetic resonance image 132 into the second noise filtering module 124.

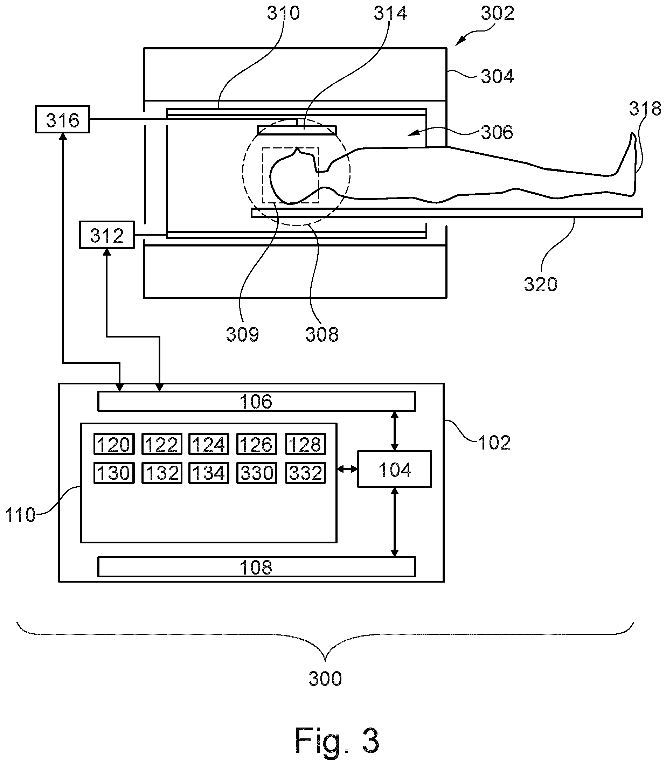

Fig. 3 illustrates a further example of a medical system 300. The medical system 300 depicted in Fig. 3 is similar to the medical system 100 in Fig. 1 except that it additionally comprises a magnetic resonance imaging system 302 that is controlled by the computational system 104.

The magnetic resonance imaging system 302 comprises a magnet 304. The magnet 304 is a superconducting cylindrical type magnet with a bore 306 through it. It is also possible to use both a split cylindrical magnet and a so-called open magnet. A split cylindrical magnet is similar to a standard cylindrical magnet, except that the cryostat has been split into two sections to allow access to the isoplane of the magnet, such magnets may for instance be used in conjunction with charged particle beam therapy. An open magnet has two magnet sections, one above the other with a space in-between that is large enough to receive a subject. The arrangement of the two sections area is similar to that of a Helmholtz coil. Open magnets are popular because the subject is less confined. Inside the cryostat of the cylindrical magnet there is a collection of superconducting coils.

Within the bore 306 of the cylindrical magnet 304 there is an imaging zone 308 where the magnetic field is strong and uniform enough to perform magnetic resonance imaging. A field of view 309 is shown within the imaging zone 308. The k-space data are acquired for the field of view 309. The region of interest could be identical with the field of view 309 or it could be a sub volume of the field of view 309. A subject 318 is shown as being supported by a subject support 320 such that at least a portion of the subject 318 is within the imaging zone 308 and the field of view 309.

Within the bore 306 of the magnet there is also a set of magnetic field gradient coils 310 which is used for the acquisition of measured k-space data to spatially encode magnetic spins within the imaging zone 308 of the magnet 304. The magnetic field gradient coils 310 are connected to a magnetic field gradient coil power supply 312. The magnetic field gradient coils 310 are intended to be representative. Typically, magnetic field gradient coils 310 contain three separate sets of coils for spatial encoding in three orthogonal spatial directions. A magnetic field gradient power supply supplies current to the magnetic field gradient coils. The current supplied to the magnetic field gradient coils 310 is controlled as a function of time and may be ramped or pulsed.

Adjacent to the imaging zone 308 is a radio frequency coil 314 for manipulating the orientations of magnetic spins within the imaging zone 308 and for receiving radio transmissions from spins also within the imaging zone 308. The radio frequency antenna may contain multiple coil elements. The radio frequency antenna may also be referred to as a channel or antenna. The radio frequency coil 314 is connected to a radio frequency transceiver 316. The radio frequency coil 314 and radio frequency transceiver 316 may be replaced by separate transmit and receive coils and a separate transmitter and receiver. It is understood that the radio frequency coil 314 and the radio frequency transceiver 316 are representative. The radio frequency coil 314 is intended to also represent a dedicated transmit antenna and a dedicated receive antenna. Likewise, the transceiver 316 may also represent a separate transmitter and receiver. The radio frequency coil 314 may also have multiple receive/transmit elements and the radio frequency transceiver 316 may have multiple receive/transmit channels. The transceiver 316 and the gradient controller 312 are shown as being connected to the hardware interface 106 of the computer system 102.

The memory 110 is further shown as containing pulse sequence commands 330 and measured k-space data 124. The pulse sequence commands are commands or data which may be converted into commands which can control the magnetic resonance imaging system 302 to acquire measured k-space data 124.

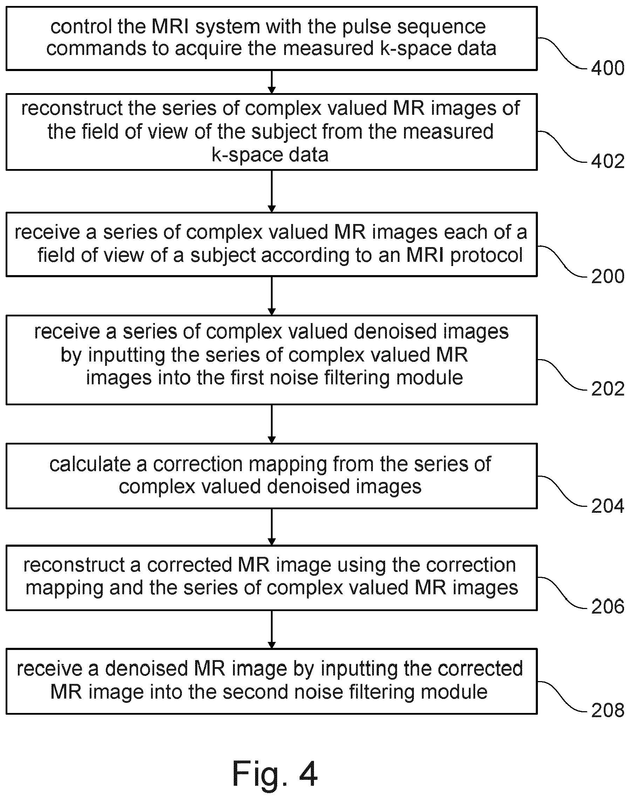

Fig. 4 shows a flow chart which illustrates a method of operating the medical system 300 of Fig. 3. The method depicted in Fig. 4 is similar to the method depicted in Fig. 2. The method in Fig. 4 starts with step 400. In step 400 the magnetic resonance imaging system 302 is controlled with the pulse sequence commands 330 so that it acquires the measured k-space data 332. Next in step 402 the series of complex valued magnetic resonance images is reconstructed from the measured k- space data 332. After step 402 is performed, steps 200, 202, 204, 206, and 208 are performed as was illustrated in Fig. 2.

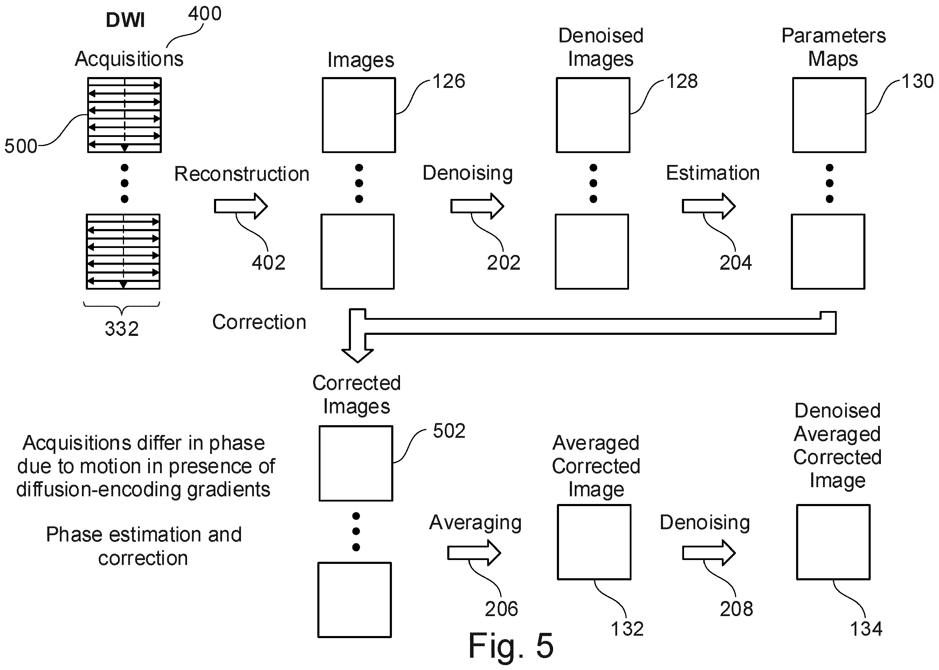

Fig. 5 illustrates a further example of a method applied for diffusion weighted imaging. Several acquisitions 400, comprising discrete measurements 500, provide measured k-space data 332. These measured k-space data are then reconstructed 402 into the series of complex valued magnetic resonance images 126. These are then denoised 202 by the first noise filtering module 122 to produce the series of complex valued denoised images 128. A calculation or estimation 204 of the correction mapping 130 follows, using the series of complex value denoised images 128. In the example of diffusion weighted imaging, the correction mapping 130 is a phase correction of the individual images 128. This phase correction 130 is applied to the series of complex valued magnetic resonance images 126 to produce the series of phase corrected images 502, to which then an averaging process 206 is applied to produce an averaged corrected image or corrected magnetic resonance image 132. The corrected magnetic resonance image 132 is finally input into the second noise filtering module 124 to produce the denoised magnetic resonance image 134.

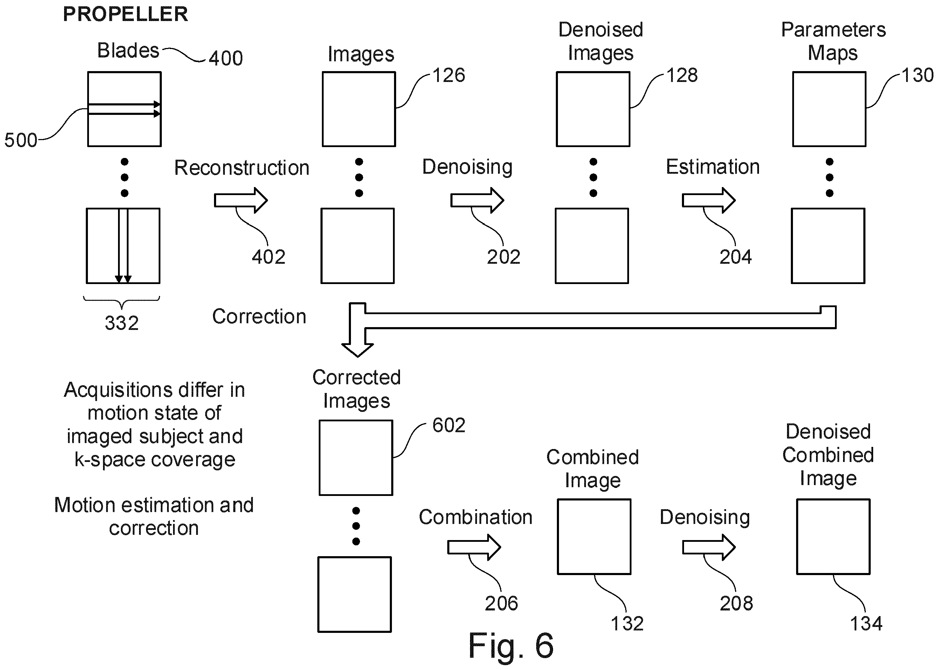

Fig. 6 illustrates a further example of a method applied for PROPELLER imaging. The acquisition comprises several individual blades 400, each providing an acquisition of measured k-space space data 332. These acquisitions of measured k-space data are reconstructed 402 into the series of complex value magnetic resonance images 126, such that one image per blade results. Then each of these blades is denoised 202 using the first noise filtering module 122 to obtain the series of complex valued denoised images 128. The correction mapping 130 is then calculated 204, which is a motion correction in this case. The motion correction 130 is applied to the original series of complex valued magnetic resonance images 126 to produce the series of motion corrected images 602. These are then combined 206 to produce a combined or corrected magnetic resonance image 132. The motion corrected images 602 for example may be transformed to k-space and the resulting k-space data may be collectively combined. The combined k-space data are then reconstructed into the corrected magnetic resonance image 132. The corrected magnetic resonance image 132 is then denoised 208 to produce the denoised magnetic resonance image 134.

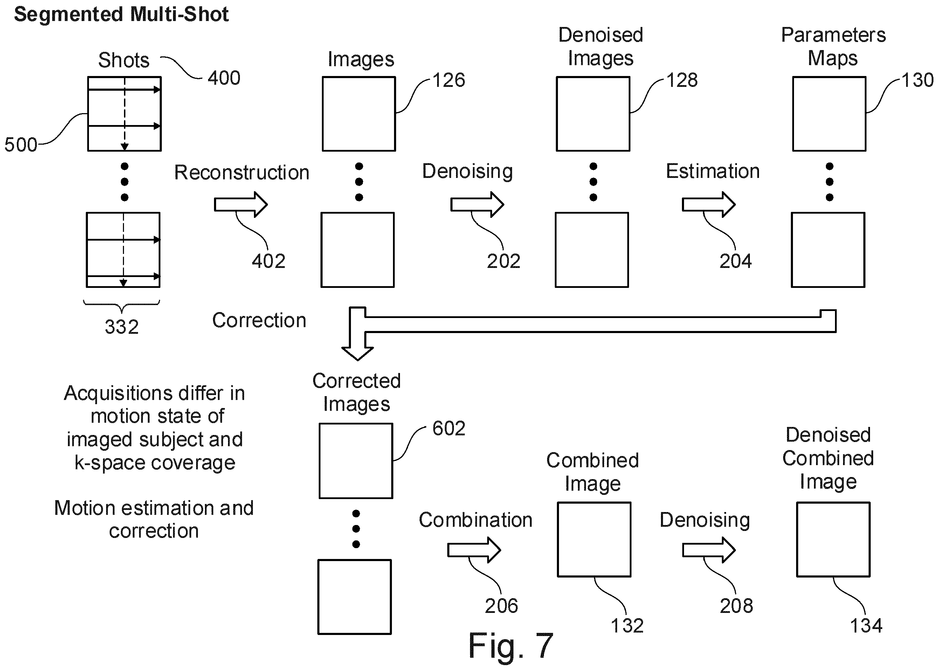

Fig. 7 illustrates another method applied for segmented multi shot magnetic resonance imaging. The acquisition is segmented into several interleaved shots 400, each providing an acquisition of measured k-space data 332. Again, these individual acquisitions are reconstructed 402 into the series of complex valued magnetic resonance images 126, such that one image per shot results. Each of these images 126 is then denoised 202 using the first noise filtering module 122 to produce the series of complex value denoised images 128. A motion estimation 204 is then performed to calculate a correction mapping 130 from the series of complex valued denoised images 128. It is again a motion correction in this case. This motion correction 130 is then applied to the original series of complex valued magnetic resonance images 126 individually to produce the motion corrected images 602.

These motion corrected images 602 are again transformed to k-space and the resulting k-space data may be collectively combined 206. The combined k-space data are then reconstructed into the corrected magnetic resonance image 132. The corrected magnetic resonance image 132 is then denoised 208 using the second noise filtering module 124 to produce the denoised combined image or denoised magnetic resonance image 134.

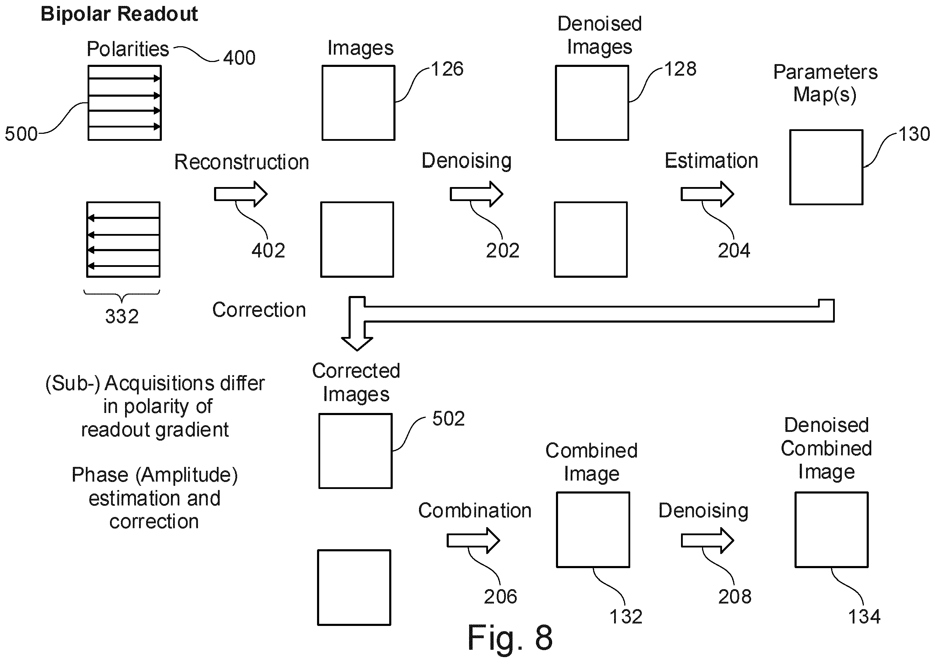

Fig. 8 illustrates another method applied for imaging with bipolar readouts. In this example, two acquisitions 400 are performed which differ in the polarity of the readout gradient. The measured k-space data 332 from these two acquisitions are again reconstructed 402 into two complex valued magnetic resonance images 126. These are then denoised with the first noise filtering module 122 to produce the complex valued denoised images 128. The correction mapping 130 is then calculated 204, which is a phase correction in this case. This correction mapping 130 is then applied to the complex valued magnetic resonance images 126 to calculate the phase corrected images 502. These two phase corrected images 502 are then transformed to k-space where they are combined 206 to reconstruct the corrected magnetic resonance image 132. The corrected magnetic resonance image 132 is then denoised 208 with the second noise filtering module 124 to produce the denoised magnetic resonance image 134.

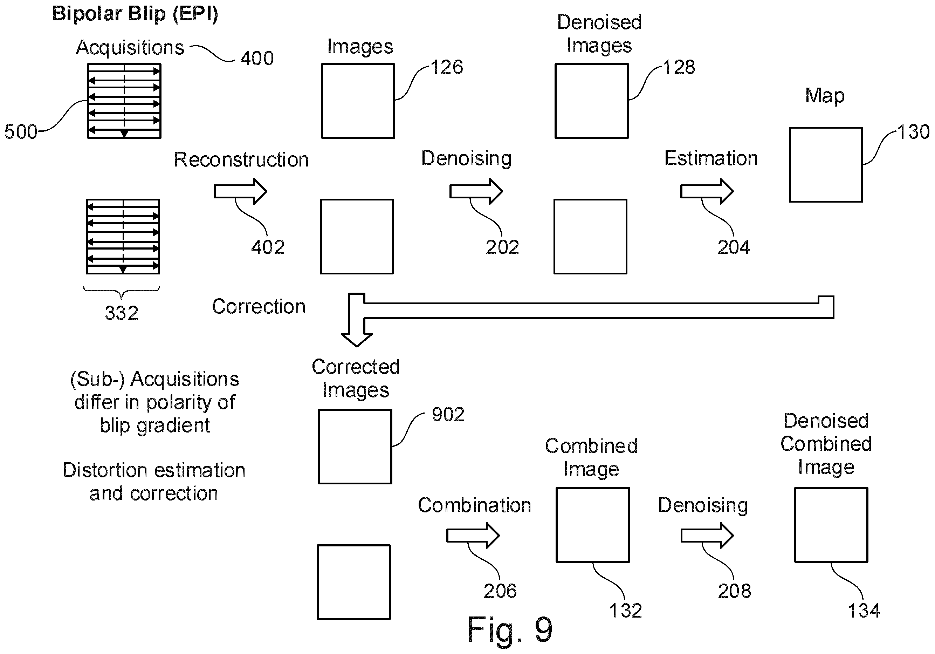

Fig. 9 illustrates another method applied for echo planar imaging with two blip gradient polarities. In this example, two acquisitions 400 are performed which differ in the polarity of the blip gradient. The measured k-space data 332 from these two acquisitions are reconstructed 402 into two complex valued magnetic resonance images 126. Using the first noise filtering module 122 they are processed into two complex valued denoised images 128. A registration is performed on these two complex valued denoised images to calculate a correction mapping 130. In this case the correction mapping 130 is a distortion correction mapping. This correction mapping 130 is then applied to the complex valued magnetic resonance images 126 to produce the distortion corrected images 902, which are combined 206 to obtain the corrected magnetic resonance image 132. The corrected magnetic resonance image 132 is then denoised 208 using the second noise filtering module 124 to produce the denoised magnetic resonance image 134.

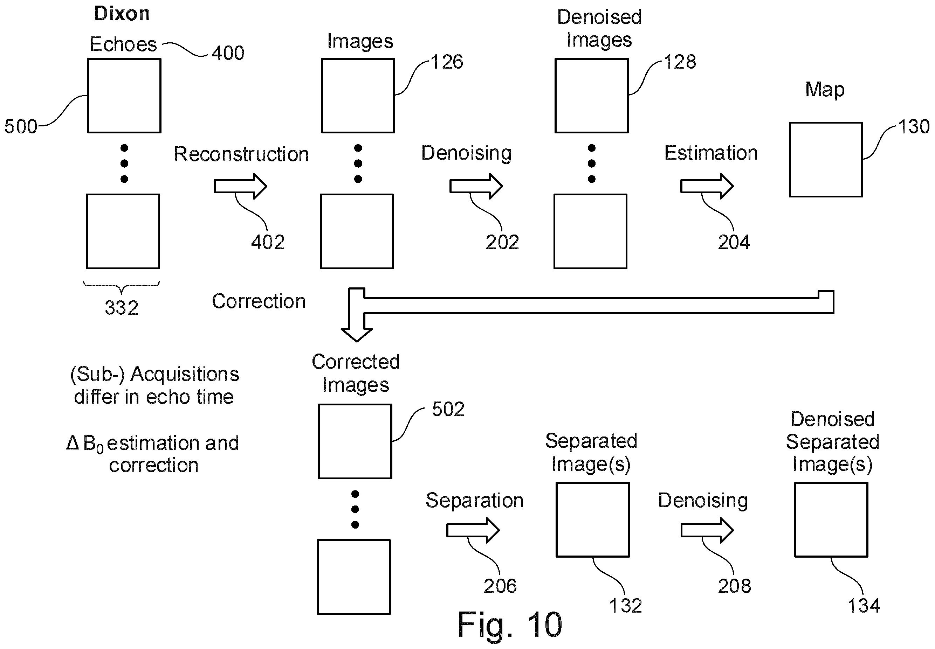

Fig. 10 illustrates an example of a method applied for Dixon magnetic resonance imaging. In this example, two or more acquisitions 400 are performed which differ in echo time. The measured k-space data 332 from these acquisitions are reconstructed 402 into the series of complex valued magnetic resonance images 126. Each of these images is then denoised 202 using the first noise filtering module 122. This produces the series of complex valued denoised images 128. In this example the calculation of the correction mapping 204 involves an estimation of the main field inhomogeneity correction mapping 130. This correction mapping 130 is then applied to the series of complex valued magnetic resonance images 126 to produce a series of phase corrected images 502. These phase corrected images 502 are then used to calculate individual Dixon images 132, such as a water-only and a fat-only image. These individual Dixon images 132 are then denoised by inputting them into the second noise filtering module 124 to provide the denoised magnetic resonance images 134 which in this case are denoised Dixon magnetic resonance images.

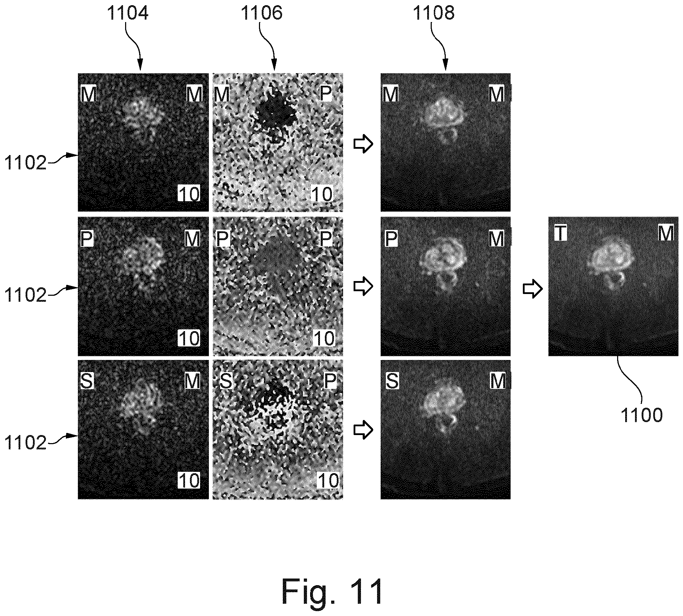

Figs. 11 through 14 illustrate the method applied to diffusion weighted magnetic resonance imaging (DWI), which is predominantly performed with single shot echo planar imaging (EPI) to reduce susceptibility to motion. However, it often provides even at moderate spatial resolution only a poor signal-to-noise ratio (SNR) and thus necessitates the acquisition of multiple averages. The phase of the individual averages is usually inconsistent due to motion, which precludes an immediate complex combination.

Under these circumstances, a diffusion weighted magnetic resonance image 1100 is typically generated as illustrated in Fig. 11. A total of 30 images were collected of each slice in this prostate case, 10 images each with 3 orthogonal directions of the diffusion sensitizing gradients (M, P, S). The magnitude 1104 and the phase 1106 of one selected image per direction is shown in the first and in the second column, respectively, where each row represents one direction. First, the magnitude images (M) are added up per direction, while the phase images (P) are ignored. The sum of magnitudes 1108 per direction is shown in the third column. Then, the trace is computed as the geometric mean over directions to obtain the trace image (T), or diffusion weighted magnetic resonance image.

A magnitude combination of the individual averages leads to an undesired accumulation of background signal, whereas an immediate complex combination risks a cancellation of foreground signal. Moreover, the low SNR of the individual averages often prevents a reliable phase correction and a decent immediate denoising.

Examples may use a two stage denoising for DWI in a low SNR regime. In the first stage, a denoising of the individual averages is carried out for the purpose of deriving a reliable phase correction only. This phase correction is then applied to the individual averages, followed by a complex combination per direction. In the second stage, the SNR is further increased by a denoising of the resulting images, prior to a combination over directions. In this way, examples may take advantage of the superior performance of complex averaging and denoising in a lower and higher SNR regime, respectively, while avoiding potential signal cancellation.

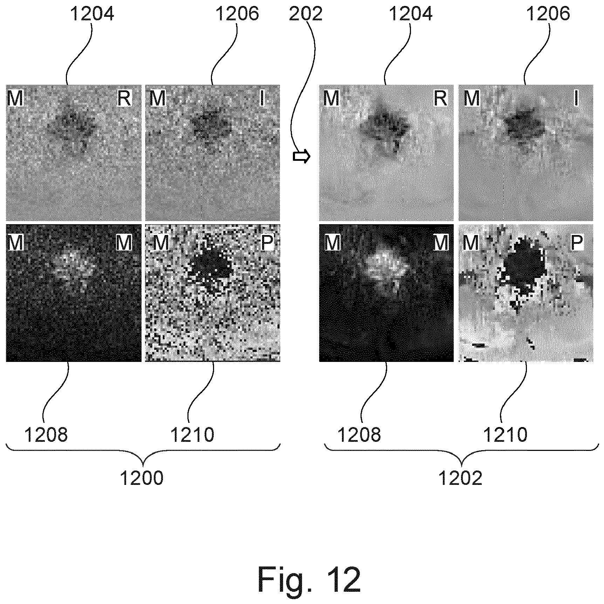

Fig. 12 illustrates a single complex valued magnetic resonance image 1200 that is input into the noise filter 202 to produce a single complex valued denoised image 1202. As this is a complex image the real component 1204, the imaginary component 1206, the magnitude 1208, and the phase 1210 are shown for both images.

It is worth noting that boosting the SNR by a mere reduction in spatial resolution is not viable because of the only moderate spatial resolution of the acquisition and the very limited image area with perceptible signal.

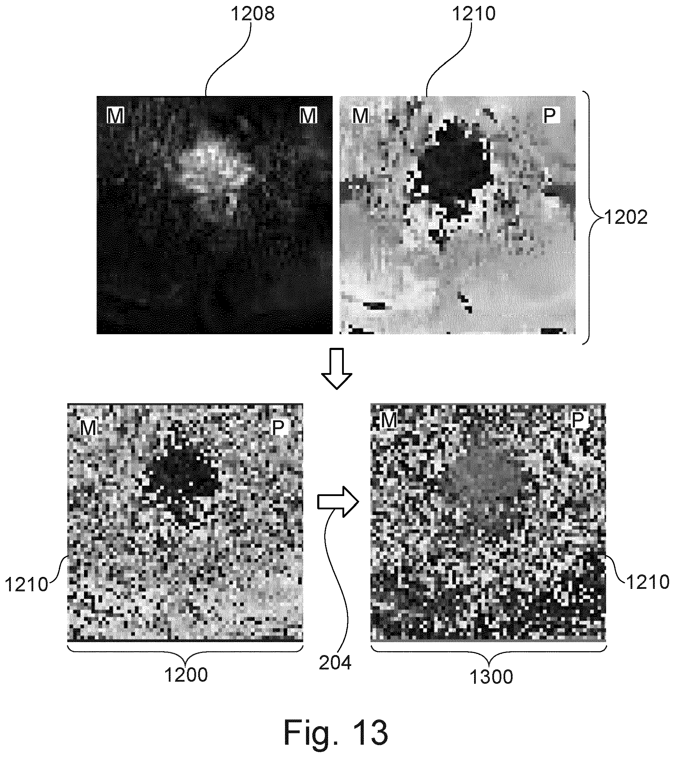

Fig. 13 shows the magnitude image 1208 and phase image 1210 for a single image 1202 of the series of complex value denoised images 128. These are used to provide a phase correction which is applied to the single complex valued magnetic resonance image 1200. The phase 1210 of this image and of the resulting image 1300 is shown as well. The phase estimation involves in this case a weighted least squares fitting of a constant and a linear phase.

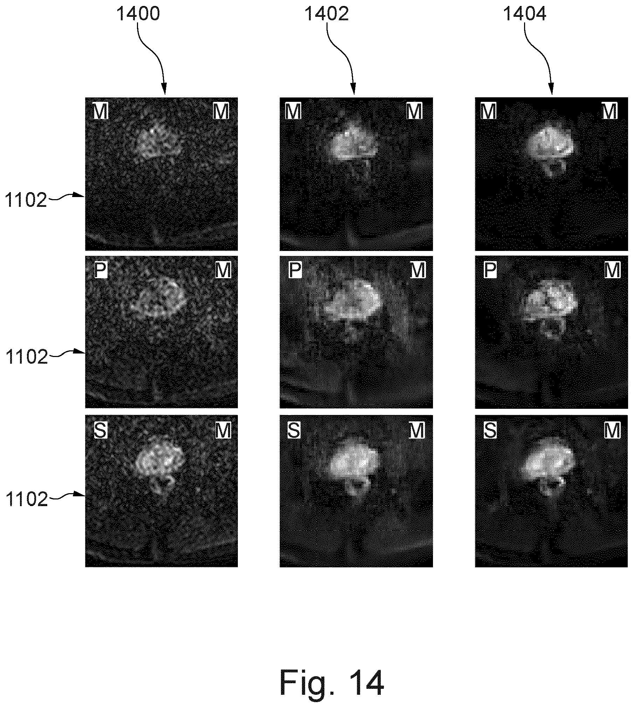

Fig. 14 illustrates the complex combination of individual averages per direction 1102. Shown are the magnitude of the complex combination of the individual averages per direction. The images in column 1400 represent the series of complex valued magnetic resonance images 126. The images in column 1402 represent the series of complex valued denoised images 128. The images in column 1404 represent the denoised magnetic resonance image 134. A comparison with Fig. 11 demonstrates a large improvement in image quality.

While the invention has been illustrated and described in detail in the drawings and foregoing description, such illustration and description are to be considered illustrative or exemplary and not restrictive; the invention is not limited to the disclosed embodiments.

Other variations to the disclosed embodiments can be understood and effected by those skilled in the art in practicing the claimed invention, from a study of the drawings, the disclosure, and the appended claims. In the claims, the word "comprising" does not exclude other elements or steps, and the indefinite article "a" or "an" does not exclude a plurality. A single processor or other unit may fulfill the functions of several items recited in the claims. The mere fact that certain measures are recited in mutually different dependent claims does not indicate that a combination of these measures cannot be used to advantage. A computer program may be stored/distributed on a suitable medium, such as an optical storage medium or a solid state medium supplied together with or as part of other hardware, but may also be distributed in other forms, such as via the Internet or other wired or wireless telecommunication systems. Any reference signs in the claims should not be construed as limiting the scope.

REFERENCE SIGNS LIST

| | |
|---|---|
| 100 | medical system |
| 102 | computer |
| 104 | computational system |
| 106 | hardware interface |
| 108 | user interface |
| 110 | memory |
| 120 | machine executable instructions |
| 122 | first noise filtering module |
| 124 | second noise filtering module |
| 126 | series of complex valued magnetic resonance images |
| 128 | series of complex valued denoised images |
| 130 | correction mapping |
| 132 | corrected magnetic resonance image |
| 134 | denoised magnetic resonance image |
| 200 | receive a series of complex valued magnetic resonance images each of a field of view of a subject according to a magnetic resonance imaging protocol |
| 202 | receive a series of complex valued denoised images by inputting the series of complex valued magnetic resonance images into the first noise filtering module |
| 204 | calculate a correction mapping from the series of complex valued denoised images |
| 206 | reconstruct a corrected magnetic resonance image using the correction mapping and the series of complex valued magnetic resonance images |
| 208 | receive a denoised magnetic resonance image by inputting the corrected magnetic resonance image into the second noise filtering module |
| 300 | medical system |
| 302 | magnetic resonance imaging system |
| 304 | magnet |
| 306 | bore of magnet |
| 308 | imaging zone |
| 309 | field of view |
| 310 | magnetic field gradient coils |
| 312 | magnetic field gradient coil power supply |
| 314 | radio frequency coil |
| 316 | transceiver |
| 318 | subject |
| 320 | subject support |
| 330 | pulse sequence commands |
| 332 | measured k-space data |
| 400 | control the magnetic resonance imaging system with the pulse sequence commands to acquire the measured k-space data |
| 402 | reconstruct the series of complex valued magnetic resonance images each of the field of view of the subject from the measured k-space data |
| 500 | discrete acquisitions of measured k-space data 332 |
| 502 | series of phase corrected images |
| 602 | motion corrected images |

| | |
|---|---|
| 902 | distortion corrected images |
| 1100 | diffusion weighted image |
| 1102 | orthogonal directions |
| 1104 | magnitude images |
| 1106 | phase images |
| 1108 | sum of magnitude images |
| 1200 | complex valued magnetic resonance image |
| 1202 | complex valued denoised image |
| 1204 | real component |
| 1206 | imaginary component |
| 1208 | magnitude |
| 1210 | phase |
| 1300 | phase corrected image |
| 1400 | sum of complex valued images |
| 1402 | sum of complex valued denoised images |
| 1404 | denoised images |

**Claims**

1. A medical system (100, 300) comprising:

   - a memory (110) storing machine executable instructions (120), a first noise filtering module (122), and a second noise filtering module (124);
   - a computational system (104), wherein execution of the machine executable instructions causes the computational system to:

      - receive (200) a series of complex valued magnetic resonance images (126) each of a field of view (309) of a subject (318) according to a magnetic resonance imaging protocol;
      - receive (202) a series of complex valued denoised images (128) by inputting the series of complex valued magnetic resonance images into the first noise filtering module;
      - calculate (204) a correction mapping (130) from the series of complex valued denoised images;
      - reconstruct (206) a corrected magnetic resonance image (132) using the correction mapping and the series of complex valued magnetic resonance images; and
      - receive (208) a denoised magnetic resonance image (134) by inputting the corrected magnetic resonance image into the second noise filtering module.

2. The medical system of claim 1, wherein the correction mapping comprises a phase correction mapping calculated for each of the series of complex valued denoised images individually, wherein execution of the machine executable instructions further causes the computational system to calculate a series of phase corrected images (502) by applying the phase correction mapping to each of the series of complex valued magnetic resonance images, and wherein the corrected magnetic resonance image is calculated from the series of phase corrected images.

3. The medical system of claim 2, wherein the phase correction mapping is calculated for each of the series of complex valued denoised images individually by fitting a parameterized polynomial to a spatially dependent phase of the series of complex valued denoised images.

4. The medical system of claim 2 or 3, wherein the magnetic resonance imaging protocol is a diffusion weighted magnetic resonance imaging protocol, wherein the corrected magnetic resonance image is calculated from the series of phase corrected images by averaging the series of phase corrected images.

5. The medical system of claim 1, wherein the correction mapping comprises a phase correction mapping calculated for the series of complex valued denoised images collectively, wherein the magnetic resonance imaging protocol is a bipolar readout magnetic resonance imaging protocol, wherein execution of the machine executable instructions further causes the computational system to calculate the corrected magnetic resonance image from the series of phase corrected images by:

   - calculating a series of phase corrected images by applying the phase correction mapping to the series of complex valued magnetic resonance images; and
- calculating phase corrected k-space data by transforming the series of phase corrected images to k-space, wherein the corrected magnetic resonance image is reconstructed from a combination of the phase corrected k-space data.

6. The medical system of claim 1 or 5, wherein the correction mapping comprises a main field inhomogeneity correction mapping calculated from the series of complex valued denoised images, wherein execution of the machine executable instructions further causes the computational system to calculate a series of phase corrected images by applying the main field inhomogeneity correction mapping to each of the series of complex valued magnetic resonance images, wherein the corrected magnetic resonance image is calculated from the series of phase corrected images.

7. The medical system of claim 6, wherein the magnetic resonance imaging protocol is a Dixon magnetic resonance imaging protocol, and wherein the corrected magnetic resonance image is a Dixon magnetic resonance image.

8. The medical system of any one of claims 1, 2, 3, and 4, wherein the magnetic resonance imaging protocol is an echo planar magnetic resonance imaging protocol configured for acquiring the series of complex valued magnetic resonance images with two blip gradient polarities, wherein the correction mapping comprises a distortion correction mapping, wherein execution of the machine executable instructions further causes the computational system to calculate the distortion correction mapping by:

   - sorting the series of complex valued magnetic resonance images into a first group with a first blip gradient polarity and a second group with a second blip gradient polarity;
   - calculating the distortion correction mapping by registering the images from the first group with the images from the second group; and
   - calculating a series of distortion corrected magnetic resonance images by applying the distortion correction mapping to the series of complex valued magnetic resonance images, wherein the corrected magnetic resonance image is reconstructed by averaging the series of distortion corrected magnetic resonance images.

9. The medical system of claim 1, wherein the correction mapping comprises a motion correction mapping calculated from the series of complex valued denoised images with respect to a reference image.

10. The medical system of claim 9, wherein execution of the machine executable instructions further causes the computational system to:

   - calculate a series of motion corrected magnetic resonance images by applying the motion correction mapping to the series of complex valued magnetic resonance images; and
   - calculate motion corrected k-space data by transforming the series of motion corrected magnetic resonance images to k-space, wherein the corrected magnetic resonance image is reconstructed from a combination of the motion corrected k-space data.

11. The medical system of claim 10, wherein the magnetic resonance imaging protocol is either a segmented multi shot magnetic resonance imaging protocol or a PROPELLER magnetic resonance imaging protocol.

12. The medical system of claim 9, 10, or 11, wherein the motion correction mapping is any one of the following: a rigid body mapping, an affine mapping, and a displacement field.

13. The medical system of anyone of the preceding claims, wherein the medical system further comprises a magnetic resonance imaging system (302), wherein the memory further comprises pulse sequence commands (330) configured to control the magnetic resonance imaging system to acquire measured k-space data (332) according to the magnetic resonance imaging protocol, wherein execution of the machine executable instructions further causes the computational system to:

   - control (400) the magnetic resonance imaging system with the pulse sequence commands to acquire the measured k-space data, wherein the measured k-space data comprises multiple discrete acquisitions each descriptive of the field of view of a subject; and
   - reconstruct (402) the series of complex valued magnetic resonance images each of the field of view of the subject from the measured k-space data.

14. A computer program comprising machine executable instructions (120), a first noise filtering module (122), and a second noise filtering module (124); wherein execution of the machine executable instructions causes a computational system to:

  - receive (200) a series of complex valued magnetic resonance images (126) each of a field of view (309) of a subject (318) according to a magnetic resonance imaging protocol;
  - receive (202) a series of complex valued denoised images (128) by inputting the series of complex valued magnetic resonance images into the first noise filtering module;
  - calculate (204) a correction mapping (130) from the series of complex valued denoised images;
  - reconstruct (206) a corrected magnetic resonance image (132) using the correction mapping and the series of complex valued magnetic resonance images; and
  - receive (208) a denoised magnetic resonance image (134) by inputting the corrected magnetic resonance image into the second noise filtering module.

15. A method of medical imaging, wherein the method comprises:

  - receiving (200) a series of complex valued magnetic resonance images (126) each of a field of view (309) of a subject (318) according to a magnetic resonance imaging protocol;
  - receiving (202) a series of complex valued denoised images (128) by inputting the series of complex valued magnetic resonance images into the first noise filtering module;
  - calculating (204) a correction mapping (130) from the series of complex valued denoised images;
  - reconstructing (206) a corrected magnetic resonance image (132) using the correction mapping and the series of complex valued magnetic resonance images; and
  - receiving (208) a denoised magnetic resonance image (134) by inputting the corrected magnetic resonance image into the second noise filtering module.

Fig. 1

receive a series of complex valued MR images each of a field of view of a subject according to an MRI protocol ⟶ 200

receive a series of complex valued denoised images by inputting the series of complex valued MR images into the first noise filtering module ⟶ 202

calculate a correction mapping from the series of complex valued denoised images ⟶ 204

reconstruct a corrected MR image using the correction mapping and the series of complex valued MR images ⟶ 206

receive a denoised MR image by inputting the corrected MR image into the second noise filtering module ⟶ 208

Fig. 2

Fig. 3

control the MRI system with the pulse sequence
commands to acquire the measured k-space data

⌐ 400

reconstruct the series of complex valued MR images of
the field of view of the subject from the measured
k-space data

⌐ 402

receive a series of complex valued MR images each of a
field of view of a subject according to an MRI protocol

⌐ 200

receive a series of complex valued denoised images
by inputting the series of complex valued MR
images into the first noise filtering module

⌐ 202

calculate a correction mapping from the series of
complex valued denoised images

⌐ 204

reconstruct a corrected MR image using the correction
mapping and the series of complex valued MR images

⌐ 206

receive a denoised MR image by inputting the corrected
MR image into the second noise filtering module

⌐ 208

# Fig. 4

DWI 400

Acquisitions

500 ⌐

┌─────────┐
│ →       │
│       ← │
│ →       │
│       ← │
│ →       │
│       ← │
│       ↓ │
└─────────┘

⋮

┌─────────┐
│ →       │
│       ← │
│ →       │
│       ← │
│ →       │
│       ← │
│       ↓ │
└─────────┘

⎵ 332 ⎵

Reconstruction ⟹ 402

Images

┌─────────┐
│         │ 126
└─────────┘

⋮

┌─────────┐
│         │
└─────────┘

Denoising ⟹ 202

Denoised Images

┌─────────┐
│         │ 128
└─────────┘

⋮

┌─────────┐
│         │
└─────────┘

Estimation ⟹ 204

Parameters Maps

┌─────────┐
│         │ 130
└─────────┘

⋮

┌─────────┐
│         │
└─────────┘

Correction ⟹

Corrected Images

┌─────────┐
│         │ 502
└─────────┘

⋮

┌─────────┐
│         │
└─────────┘

Acquisitions differ in phase due to motion in presence of diffusion-encoding gradients

Phase estimation and correction

Averaging ⟹ 206

Averaged Corrected Image

┌─────────┐
│         │
└─────────┘
132

Denoising ⟹ 208

Denoised Averaged Corrected Image

┌─────────┐
│         │
└─────────┘
134

Fig. 5

## Fig. 6

**PROPELLER**

Blades 400 — 500

332

↑↑ — Reconstruction 402 → Images 126 → Denoising 202 → Denoised Images 128 → Estimation 204 → Parameters Maps 130

Reconstruction 402

Correction →

Corrected Images 602 → Combination 206 → Combined Image 132 → Denoising 208 → Denoised Combined Image 134

Acquisitions differ in motion state of imaged subject and k-space coverage

Motion estimation and correction

**Segmented Multi-Shot**

Fig. 7

EP 4 321 891 A1

Fig. 8

**Bipolar Blip (EPI)**

Acquisitions — 400

Images — 126

Denoised Images — 128

Map — 130

500

Reconstruction

Denoising

Estimation

332

402

202

204

Correction

(Sub-) Acquisitions differ in polarity of blip gradient

Distortion estimation and correction

Corrected Images — 902

Combined Image — 132

Denoised Combined Image — 134

Combination

Denoising

206

208

Fig. 9

EP 4 321 891 A1

**Dixon**

Echoes 400

500

332

Reconstruction
402

Images 126

Denoising
202

Denoised Images 128

Estimation
204

Map 130

(Sub-) Acquisitions differ in echo time

$\Delta B_0$ estimation and correction

Correction

Corrected Images 502

Separation
206

Separated Image(s) 132

Denoising
208

Denoised Separated Image(s) 134

Fig. 10

Fig. 11

Fig. 12

Fig. 13

Fig. 14

| | Europäisches Patentamt European Patent Office Office européen des brevets | **EUROPEAN SEARCH REPORT** | **Application Number** EP 22 18 9932 |
|---|---|---|---|

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 2013/187652 A1 (HU PENG [US]; NEZAFAT REZA [US]; BETH ISRAEL HOSPITAL [US]) 25 July 2013 (2013-07-25) | 1-5,9-15 | INV. G01R33/56 G01R33/565 |
| A | * paragraph [0049] – paragraph [0060]; figures 1,2 * | 6-8 | |
| A | US 2022/244334 A1 (SACOLICK LAURA [US] ET AL) 4 August 2022 (2022-08-04) * paragraph [0065] * | 1-15 | |
| A | SAMUEL ST-JEAN, ALBERTO DE LUCA, MAX A. VIERGEVER AND ALEXANDER LEEMANS: "nvestigating noise distribution changes after motion correction and its effects on subsequent diffusion MRI processing", INTERNATIONAL SOCIETY FOR MAGNETIC RESONANCE IN MEDICINE, ISMRM, 2030 ADDISON STREET, 7TH FLOOR, BERKELEY, CA 94704 USA, no. 1574, 1 June 2018 (2018-06-01), XP040700782, * Method * | 1-15 | |
| A | BRAILEAN J C ET AL: "NOISE REDUCTION FILTERS FOR DYNAMIC IMAGE SEQUENCES: A REVIEW", PROCEEDINGS OF THE IEEE, IEEE. NEW YORK, US, vol. 83, no. 9, 1 September 1995 (1995-09-01), pages 1272-1291, XP000526001, ISSN: 0018-9219, DOI: 10.1109/5.406412 * the whole document * | 1-15 | TECHNICAL FIELDS SEARCHED (IPC) G01R |

-/--

The present search report has been drawn up for all claims

| Place of search | Date of completion of the search | Examiner |
|---|---|---|
| Munich | 23 January 2023 | Ó Donnabháin, C |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

page 1 of 3

Europäisches
Patentamt

European
Patent Office

Office européen
des brevets

**EUROPEAN SEARCH REPORT**

Application Number

EP 22 18 9932

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| A | HOINKISS DANIEL CHRISTOPHER ET AL: "Prospective motion correction in functional MRI using simultaneous multislice imaging and multislice-to-volume image registration", NEUROIMAGE, ELSEVIER, AMSTERDAM, NL, vol. 200, 19 June 2019 (2019-06-19), pages 159-173, XP085776094, ISSN: 1053-8119, DOI: 10.1016/J.NEUROIMAGE.2019.06.042 [retrieved on 2019-06-19] * figure 1 * * 2.2 Kalman filtering to smooth motion parameter estimates * ----- | 1-15 | |
| A | LIU YAN ET AL: "Field-inhomogeneity-corrected low-rank filtering of magnetic resonance spectroscopic imaging data", 2014 36TH ANNUAL INTERNATIONAL CONFERENCE OF THE IEEE ENGINEERING IN MEDICINE AND BIOLOGY SOCIETY, IEEE, 26 August 2014 (2014-08-26), pages 6422-6425, XP032675777, DOI: 10.1109/EMBC.2014.6945098 [retrieved on 2014-11-02] * 4.1 Bias field correction and noise filtering * ----- | 1-15 | TECHNICAL FIELDS SEARCHED (IPC) |

-/--

The present search report has been drawn up for all claims

| Place of search | Date of completion of the search | Examiner |
|---|---|---|
| Munich | 23 January 2023 | Ó Donnabháin, C |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

page 2 of 3

Europäisches
Patentamt

European
Patent Office

Office européen
des brevets

## EUROPEAN SEARCH REPORT

**Application Number**

**EP 22 18 9932**

### DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| A | CHOWDHURY NAJEEB ET AL: "Linked statistical shape models for multi-modal segmentation: application to prostate CT-MR segmentation in radiotherapy planning",<br>MEDICAL IMAGING 2011: COMPUTER-AIDED DIAGNOSIS, SPIE, 1000 20TH ST. BELLINGHAM WA 98225-6705 USA,<br>vol. 7963, no. 1,<br>3 March 2011 (2011-03-03), pages 1-15,<br>XP060008531,<br>DOI: 10.1117/12.878416<br>[retrieved on 2011-03-15]<br>----- | 1-15 | |

TECHNICAL FIELDS
SEARCHED        (IPC)

The present search report has been drawn up for all claims

| Place of search | Date of completion of the search | Examiner |
|---|---|---|
| Munich | 23 January 2023 | Ó Donnabháin, C |

CATEGORY OF CITED DOCUMENTS

X : particularly relevant if taken alone
Y : particularly relevant if combined with another
    document of the same category
A : technological background
O : non-written disclosure
P : intermediate document

T : theory or principle underlying the invention
E : earlier patent document, but published on, or
    after the filing date
D : document cited in the application
L : document cited for other reasons

& : member of the same patent family, corresponding
    document

EPO FORM 1503 03.82 (P04C01)

page 3 of 3

## ANNEX TO THE EUROPEAN SEARCH REPORT
## ON EUROPEAN PATENT APPLICATION NO.

EP 22 18 9932

This annex lists the patent family members relating to the patent documents cited in the above-mentioned European search report.
The members are as contained in the European Patent Office EDP file on
The European Patent Office is in no way liable for these particulars which are merely given for the purpose of information.

23-01-2023

| Patent document cited in search report | Publication date | Patent family member(s) | Publication date |
|---|---|---|---|
| US 2013187652 A1 | 25-07-2013 | US 2011175609 A1<br>US 2013187652 A1 | 21-07-2011<br>25-07-2013 |
| US 2022244334 A1 | 04-08-2022 | US 2022244334 A1<br>WO 2022169626 A1 | 04-08-2022<br>11-08-2022 |

EPO FORM P0459

For more details about this annex : see Official Journal of the European Patent Office, No. 12/82

**EP 4 321 891 A1**

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description

- US 2022026516 A1